# EUROPEAN PATENT APPLICATION

(11) **EP 4 694 639 A1**
(43) Date of publication of application: **11.02.2026**
(21) Application number: 23929601.5
(22) Date of filing: 21.04.2023
(51) Int. Cl.: H10K 50/844, H10K 59/10

(54) **DISPLAY PANEL AND ELECTRONIC DEVICE**

(30) Priority: 28.03.2023 CN 202310317126
(71) Applicant: Wuhan China Star Optoelectronics Semiconductor Display Technology Co., Ltd., Wuhan, Hubei 430079 (CN)
(72) Inventor: YAN, Xinkun, Wuhan, Hubei 430079 (CN)
(74) Representative: Studio Torta S.p.A.
(86) International application number: PCT/CN2023/089910
(87) International publication number: WO 2024/198021

(57) **Abstract**

A display panel and an electronic device are disclosed, by forming an insulation part covering one side of a metal barrier part in the transition area, a first electrode layer located at one side of the metal barrier part is electrically connected to the metal barrier part, and the first electrode layer located at another side of the metal barrier part is insulated with the metal barrier part through the insulation part, so that the first electrode layer close to a functional area does not form an electric field, alleviating the problem of encapsulation failure in the cutting edge area of the punch-hole screen.

## Description

### TECHNICAL FIELD

The present disclosure relates to the field of display technologies, and particularly relates to a display panel and an electronic device.

### BACKGROUND

With a development of display technologies, display devices of the prior art are designed towards a high screen ratio to achieve a full-screen. Punch-hole screen design is one of methods for increasing the screen ratio. During a production process of the punch-hole screen, laser cutting (O-CUT) is required on a display area, and organic luminescent materials at edges of a cutting channel are easy to become a transportation channel for external water and oxygen, special structures commonly need to be disposed in the cutting edge area to interrupt a connection of organic materials and block path of water vapor invasion, in order to improve a reliability of encapsulation in the cutting edge area. However, in a high temperature and humidity reliability testing environment, the K element in the polarizer of the punch-hole screen may dissolve in water. When the punch-hole screen is on a display state, a cathode in the cutting edge area is in a charged state, the existing electric field may cause K⁺ to migrate to the encapsulation layer and undergo electrochemical reactions with the silicon oxide in the encapsulation layer, and the electrochemical reactions may cause the encapsulation layer to expand and deform, leading to encapsulation failure.

### SUMMARY

A display panel and an electronic device are provided by the present disclosure, to alleviate a technical problem of encapsulation failure in cutting edge areas of punch-hole screens.

To solve the above problem, the technical solutions provided by the present disclosure are as follows.

A display panel provided by the embodiments of the present disclosure includes a functional area, a display area and a transition area located between the functional area and the display area, and the display panel further includes:
a substrate;
an inorganic insulation layer disposed on a side of the substrate;
a first metal layer disposed on a side of the inorganic insulation layer away from the substrate, the first metal layer including at least one metal barrier part disposed in the transition area, at least one side of the metal barrier part being provided with a disconnection structure;
an organic insulation layer disposed on a side of the first metal layer away from the substrate, the organic insulation layer including at least one insulation part disposed in the transition area and covering corresponding one side of the metal barrier part;
a light emitting layer disposed on a side of the organic insulation layer away from the substrate, covering the display area and extending to the transition area, and disconnected at the disconnection structure of the metal barrier part; and
a first electrode layer disposed on a side of the light emitting layer away from the substrate, covering the display area and extending to the transition area, and disconnected at the disconnection structure of the metal barrier part; and
the first electrode layer located at one side of the metal barrier part is electrically connected to the metal barrier part, and the first electrode layer located at another side of the metal barrier part is insulated with the metal barrier part through the insulation part.

**In** the display panel provided in an embodiment of the present disclosure, the first metal layer includes a plurality of metal barrier parts disposed in the transition area,
one side of at least one of the metal barrier parts is provided with the disconnection structure, and another side of the one of the metal barrier parts is covered by a corresponding insulation part.

**In** the display panel provided in an embodiment of the present disclosure, one side of at least one of the metal barrier parts close to the display area is provided with the disconnection structure, one side of the one of the metal barrier parts close to the functional area is covered by the corresponding insulation part, the one of the metal barrier parts is electrically connected with the first electrode layer close to the display area at the disconnection structure, and the one of the metal barrier parts is insulated with the first electrode layer close to the functional area through the insulation part.

**In** the display panel provided in an embodiment of the present disclosure, the first metal layer includes a first metal barrier part and a second metal barrier part adjacent to each other disposed in the transition area, and the first metal barrier part is disposed between the second metal barrier part and the display area;
one side of the first metal barrier part close to the display area is provided with the disconnection structure, and one side of the second metal barrier part close to the functional area is provided with the disconnection structure;
one side of the first metal barrier part close to the functional area and one side of the second metal barrier part close to the display area are covered simultaneously by the insulation part;
the light emitting layer is disconnected at the disconnection structure which is disposed at the side of the first metal barrier part close to the display area, and is disconnected at the disconnection structure which is disposed at the side of the second metal barrier part close to the functional area, and the light emitting layer is continuously disposed between the side of the first metal barrier part close to the display area and the side of the second metal barrier part close to the functional area; and
the first electrode layer is disconnected at the disconnection structure which is disposed at the side of the first metal barrier part close to the display area, and is disconnected at the disconnection structure which is disposed at the side of the second metal barrier part close to the functional area, a first electrode layer located at the side of the first metal barrier part close to the display area is electrically connected to the first metal barrier part, and a first electrode layer located at the side of the second metal barrier part close to the functional area is electrically connected to the second metal barrier part.

**In** the display panel provided in an embodiment of the present disclosure, the display panel further includes:
a barrier wall disposed in the transition area and disposed on a side of the inorganic insulation layer away from the substrate;
the transition area includes a first subarea located between the barrier wall and the display area and a second subarea located between the barrier wall and the functional area; and
the organic insulation layer includes the at least one insulation part covering corresponding one side of the metal barrier part, and the insulation part is disposed in the first subarea and/or the second subarea.

**In** the display panel provided in an embodiment of the present disclosure, the first metal barrier part and the second metal barrier part are disposed in the first subarea; and
a same voltage is applied to the first metal barrier part and the first electrode layer, and no voltage is applied to the second metal barrier part.

**In** the display panel provided in an embodiment of the present disclosure, a number of insulation parts is less than or equal to a number of metal barrier parts.

**In** the display panel provided in an embodiment of the present disclosure, the metal barrier part includes a first metal sublayer, a second metal sublayer and a third metal sublayer stacked sequentially, a material of the second metal sublayer is different from a material of the third metal sublayer, and a width of the second metal sublayer is smaller than a width of the third metal sublayer.

**In** the display panel provided in an embodiment of the present disclosure, the display panel further includes a first planarization layer, a pixel definition layer and a support layer disposed stacked sequentially on the first metal layer, and the organic insulation layer is formed by at least one of the first planarization layer, the pixel definition layer and the support layer.

**In** the display panel provided in an embodiment of the present disclosure, the inorganic insulation layer includes a first inorganic insulation sublayer, a second inorganic insulation sublayer, a third inorganic insulation sublayer, and a fourth inorganic insulation sublayer stacked sequentially on the substrate; and
the display panel further includes:
a semiconductor layer disposed between the first inorganic insulation sublayer and the second inorganic insulation sublayer, and including a plurality of active parts disposed in the display area;
a second metal layer disposed between the second inorganic insulation sublayer and the third inorganic insulation sublayer, including a plurality of gates and a plurality of first capacitive electrodes disposed in the display area, and the gates corresponding to the active parts; and
a third metal layer disposed between the third inorganic insulation sublayer and the fourth inorganic insulation sublayer, including a plurality second capacitive electrodes disposed in the display area, and the second capacitive electrodes corresponding to the first capacitive electrodes; and
the second metal layer further includes a first pad layer structure disposed in the transition area and corresponding to the metal barrier part, and/or the third metal layer further includes a second pad layer structure disposed in the transition area and corresponding to the metal barrier part.

An electronic device is further provided by the embodiments of the present disclosure, the electronic device includes a functional component and a display panel in one of the foregoing embodiments, and the functional component corresponds to the functional area of the display area.

### BENEFICIAL EFFECTS

In the display panel and the electronic device of the present disclosure, the display panel includes a functional area, a display area and a transition area located between the functional area and the display area. The first metal layer of the display panel is disposed on a side of the inorganic insulation layer away from the substrate, at least one metal barrier part is disposed in the transition area, and at least one side of the metal barrier part is provided with the disconnection structure. The organic insulation layer is provided with the insulation part which covers one side of the metal barrier part and is in the transition area. The light emitting layer and the first electrode layer are disconnected at the disconnection structure. The first electrode layer located at one side of the metal barrier part is electrically connected to the metal barrier part, and the first electrode layer located at another side of the metal barrier part is insulated with the metal barrier part through the insulation part. Therefore, the first electrode layer close to the functional area is insulated with and the first electrode layer in the display area, and the first electrode layer close to the functional area may not form an electric field, thereby preventing a migration of K⁺ in a polarizer to an encapsulation layer and electrochemical reactions, and solving the problem of encapsulation failure in the cutting edge area of the punch-hole screen of the prior art.

### DESCRIPTION OF DRAWINGS

To describe the technical solutions of the embodiments of the present disclosure or the prior art more clearly, the following briefly introduces the accompanying drawings used in the description of the embodiments of the present disclosure or the prior art. Apparently, the accompanying drawings described below illustrate only some exemplary embodiments of the present disclosure, and persons skilled in the art may derive other drawings from the drawings without making creative efforts.
FIG. 1 is a top schematic view of a display panel provided in an embodiment of the present disclosure.
FIG. 2 is a cross-sectional schematic view along a direction A-A' in FIG. 1.
FIG. 3 is a detailed schematic view of the first subarea in FIG. 2.
FIG. 4 is a detailed schematic view of the display area in FIG. 2.
FIG. 5 is a detailed schematic view of the metal barrier part in FIG. 2.
FIG. 6 is another a cross-sectional schematic view along the direction A-A' in FIG. 1.
FIG. 7 is a detailed schematic view of the first subarea SA1 in FIG. 6.
FIG. 8 is another a cross-sectional schematic view along the direction A-A' in FIG. 1.
FIG. 9 is another a detailed schematic view of the display area provided in an embodiment of the present disclosure.
FIG.10 is a detailed schematic view of the structure of the first subarea of the film layers in FIG. 9.

### DETAILED DESCRIPTION OF EMBODIMENTS

The following description of every embodiment with reference to the accompanying drawings is used to exemplify a specific embodiment which may be carried out in the present disclosure. Directional terms mentioned in the present disclosure, such as "top", "bottom", "front", "back", "left", "right", "inside", "outside", "side" etc., are only used with reference to orientations of the accompanying drawings. Therefore, the used directional terms are intended to illustrate, but not to limit the present disclosure. In the accompanying drawings, units with similar structures are indicated by a same number. In the accompanying drawings, the thickness of some layers and areas are exaggerated for clarity and ease of description. That is, the size and thickness of each component shown in the accompanying drawings are arbitrary, but the present disclosure is not limited to this.

In response to the problem of encapsulation failure in a cutting edge area of a punch-hole screen of the prior art, the inventor of the present disclosure found in his research that in a high temperature and high humidity reliability testing environment, the K element of a polarizer in the cutting edge area of the punch-hole screen may dissolve in water to form potassium hydroxide (KOH). When the punch-hole screen is in a display state, a cathode may be in a charged state due to its electrical connection to a cathode in the display area. An electric field formed by the charged cathode may cause K⁺ to migrate to an encapsulation layer and undergo an electrochemical reaction with silicon oxide (SiOₓ) of the encapsulation layer. The electrochemical reaction may cause the encapsulation layer to expand and deform, leading to encapsulation failure.

To solve the above problem, a display panel and an electronic device are provided by the present disclosure.

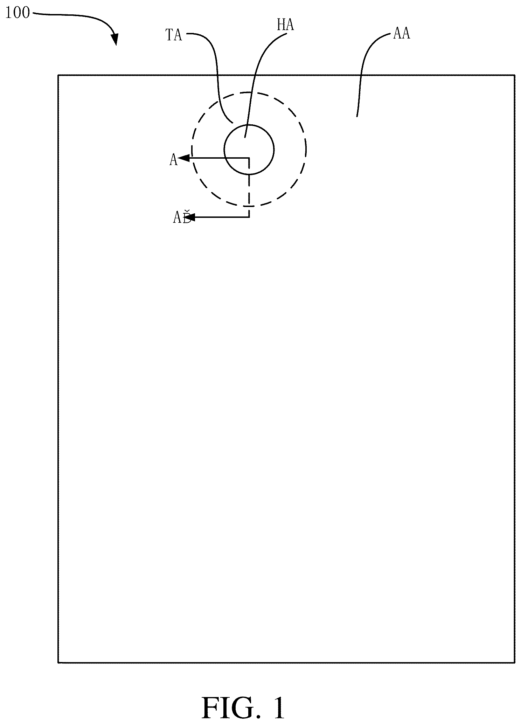

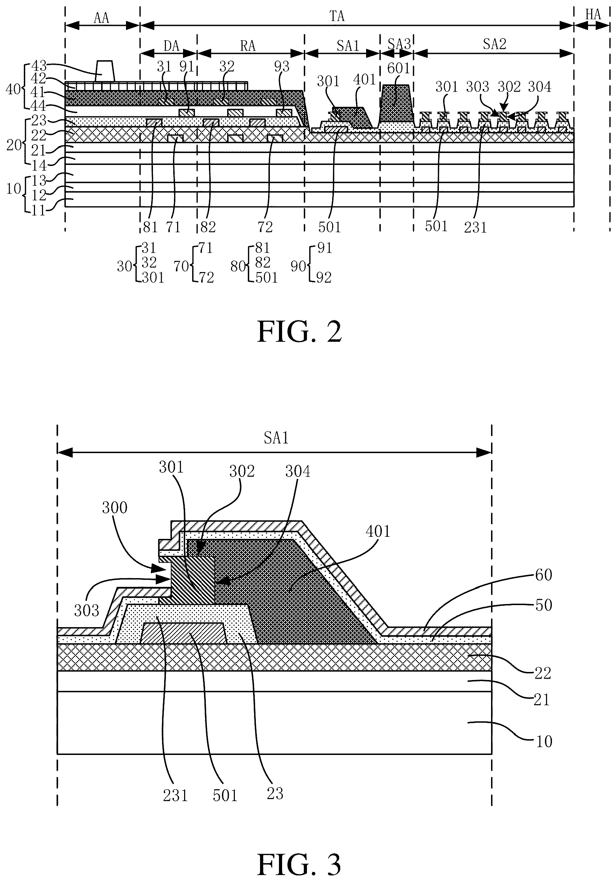

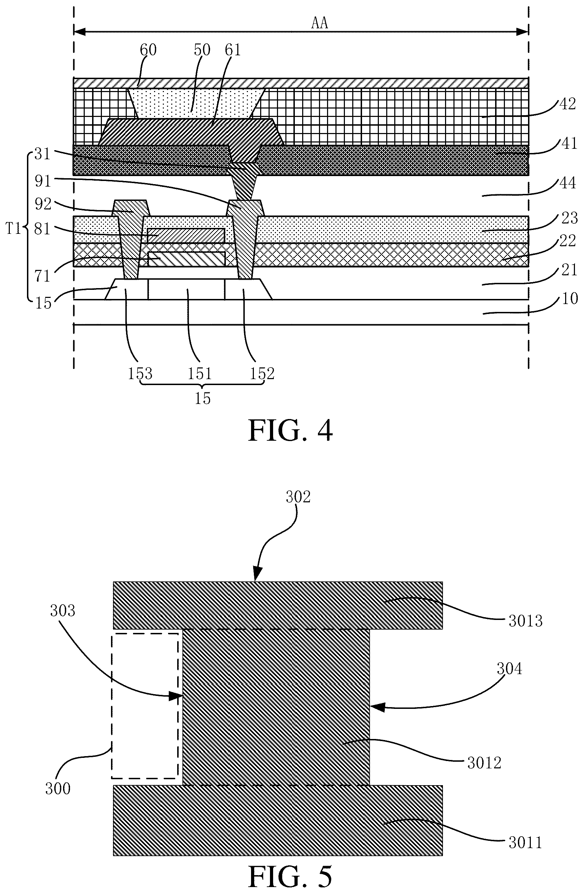

Referring to FIGS. 1 to 5, FIG. 1 is a top schematic view of a display panel provided in an embodiment of the present disclosure. FIG. 2 is a cross-sectional schematic view along a direction A-A' in FIG. 1, FIG. 3 is a detailed schematic view of the first subarea in FIG. 2, FIG. 4 is a detailed schematic view of the display area in FIG. 2, and FIG. 5 is a detailed schematic view of the metal barrier part in FIG. 2. Referring to FIG. 1, the display panel 100 includes a functional area HA, a display area AA adjacent to the functional area HA, and a transition area TA located between the functional area HA and the display area AA.

The display area AA is used for displaying pictures, and the functional area HA may be located in any area of the display panel 100, for example, the functional area HA may be located in a middle or an edge area of the display panel 100. The functional area HA is provided with a through hole that runs through a plurality of film layers of the display panel 100. Functional components such as an earphone, a camera, and various sensors may be placed inside the through hole to achieve functions such as camera under the screen and fingerprints under the screen, thereby increasing a screen ratio of the display panel 100.

The transition area TA is located between the functional area HA and the display area AA. The transition area TA is configured to place various signal connection lines to transfer signal lines blocked by the functional area HA, such as data lines, source lines, etc. The transition area TA is further configured to dispose an encapsulation structure to avoid affecting the encapsulation effectiveness of the display panel 100 due to the disposition of the functional area HA. When the functional area HA is located in the middle area of the display panel 100, the transition area TA surrounds the functional area HA. When the functional area HA is located in the edge area of the display panel 100, the transition area TA semi surrounds the functional area HA.

Specifically, referring to FIG. 2, the display panel 100 further includes a substrate 10 and an inorganic insulation layer 20, a first metal layer 30, an organic insulation layer 40, a light emitting layer 50, and a first electrode layer 60 sequentially disposed on the substrate 10.

The inorganic insulation layer 20 is disposed on one side of the substrate 10. The first metal layer 30 is disposed on the side of the inorganic insulation layer 20 away from the substrate 10, the first metal layer 30 includes at least one metal barrier part 301 disposed in the transition area TA, and at least one side of the metal barrier part 301 is provided with a disconnection structure 300. The organic insulation layer 40 is disposed on a side of the first metal layer 30 away from the substrate 10, and the organic insulation layer 40 includes at least one insulation part 401 located in the transition area TA and covering one side of the corresponding metal barrier part 301.

Referring to FIG. 3, the light emitting layer 50 is disposed on a side of the organic insulation layer 40 away from the substrate 10, the light emitting layer 50 covers the display area AA and extends to the transition area TA, and the light emitting layer 50 is disconnected at the disconnection structure 300 of the metal barrier part 301. The first electrode layer 60 is disposed on a side of the light emitting layer 50 away from the substrate 10, and covers the display area AA and extends to the transition area TA. The first electrode layer 60 is disconnected at the disconnection structure 300 of the metal barrier part 301. A first electrode layer 60 located at one side of the metal barrier part 301 is electrically connected to the metal barrier part 301, and a first electrode layer 60 located at another side of the metal barrier part 301 is insulated with the metal barrier part 301 through the insulation part 401.

In an embodiment, referring to FIGS. 2 and 3, the first metal layer 30 includes a plurality of metal barrier part 301 disposed in the transition area TA. At least one side of the metal barrier part 301 is provided with a disconnection structure 300, and the other side of the metal barrier part 301 is covered by the corresponding insulation part 401. Specifically, one side of at least one of the metal barrier parts 301 close to the display area AA is provided with a disconnection structure 300, and another side of the one of the metal barrier parts 301 close to the functional area HA is covered by the corresponding insulation part 401. The metal barrier part 301 is electrically connected to a first electrode layer 60 close to the display area AA at the disconnection structure 300, and the metal barrier part 301 is insulated with the first electrode layer 60 close to the functional area HA through the insulation part 401.

In the embodiment, by coating the insulation part 401 on one side of the metal barrier part 301, when the first electrode layer 60 is disconnected at the disconnection structure 300 of the metal barrier part 301, a first electrode layer 60 located at one side of the metal barrier part 301 is electrically connected to the metal barrier part 301, and a first electrode layer 60 located at another side of the metal barrier part 301 is insulated with the metal barrier part 301 through the insulation part 401. Therefore, the first electrode layer 60 close to the functional area HA is insulated with and the first electrode layer 60 in the display area AA, and the first electrode layer 60 close to the functional area HA may not form an electric field, thereby preventing a migration of K⁺ in the polarizer to the encapsulation layer and electrochemical reactions, and solving the problem of encapsulation failure in the cutting edge area of the punch-hole screen of the prior art.

A film layer structure of the display panel 100 and a principle that the first electrode layer 60 located in the transition area TA may not form an electric field is explained in detail below.

Continuing with reference to FIG. 2, the transition area TA includes a first subarea SA1 and a second subarea SA2, the second subarea SA2 is located at a side of the first subarea SA1 away from the display area AA, and at least one metal barrier part 301 is disposed in the first subarea SA 1. A plurality of metal barrier parts 301 are disposed in the second subarea SA2. The organic insulation layer 40 includes at least one insulation part 401 covering one side of the corresponding metal barrier part 301, the insulation parts 401 is disposed in the first subarea SA1 and/or the second subarea SA2. Optionally, the number of the insulation parts 401 is less than or equal to the number of the metal barrier parts 301. In this way, an insulation part 401 may be disposed corresponding to each metal barrier part 301, forming a plurality of disconnection structures, so that a cathode (i.e. the first electrode layer 60) may be disconnected a plurality of times in the transition area TA, ensuring that the disconnected cathode close to the functional area HA and the metal barrier part 301 are not charged, and avoiding a formation of electric fields close to the functional area HA. In practical applications, it is also possible to dispose less insulation parts 401, such as insulation parts 401 are disposed as close as possible to the display area, which is capable of increasing the area of the uncharged cathode and further weaken the impact of the electric field formed by the charged cathode on the functional area.

The transition area TA further includes a winding area RA and a dummy pixel area DA. The winding area RA is located at a side of the first subarea SA1 close to the display area AA. The winding area RA is mainly used for disposing various signal connection lines. The dummy pixel area DA is located at a side of the winding area RA close to the display area AA, and the dummy pixel area DA is provided with a same pixel layout as the display area AA, but pixels of the dummy pixel area DA are not used for display.

Optionally, the substrate 10 may be a rigid substrate or a flexible substrate; When the substrate 10 is a rigid substrate, the substrate 10 may include a hard substrate such as a glass substrate. When the substrate 10 is a flexible substrate, the substrate 10 may include a flexible substrate such as a polyimide (PI) film, an ultra-thin glass film, etc. The flexible display panel 100 is capable of being made by the flexible substrate 10 as a substrate to achieve the special performance of the display panel 100, such as bending or curling.

An embodiment of the present disclosure takes a flexible substrate as the substrate 10 as an example, and the substrate 10 may include a flexible film and an inorganic film disposed alternately in layers. For example, the substrate 10 includes a first polyimide film 11, a barrier layer 12, and a second polyimide film 13 disposed in layers. In this way, while achieving the flexibility of the substrate 10, it may also enhance the water and oxygen resistance performance of the substrate 10.

Optionally, materials of the barrier layer 12 may include inorganic materials such as silicon oxide (SiOₓ), silicon nitride (SiNₓ), silicon oxynitride (SiON), etc.

Referring to FIG. 2, the inorganic insulation layer 20 is disposed on a side of the second polyimide film 13 away from the barrier layer 12, the inorganic insulation layer 20 extends from the display area AA to the transition area TA, and a material of the inorganic insulation layer 20 is an inorganic material. The inorganic insulation layer 20 includes a first inorganic insulation sublayer 14, a second inorganic insulation sublayer 21, a third inorganic insulation sublayer 22, and a fourth inorganic insulation sublayer 23 stacked sequentially on the second polyimide film 13. The first inorganic insulation sublayer 14 may further prevent unwanted impurities or pollutants (such as moisture, oxygen, etc.) spreading from the substrate 10 to devices that may be damaged by the impurities or pollutants, while also providing a flat top surface.

The display panel 100 further includes a semiconductor layer 15, a second metal layer 70 and a third metal layer 80. The semiconductor layer 15 is disposed between the first inorganic insulation layer 14 and the second inorganic insulation layer 21, and the semiconductor layer 15 includes a plurality of active parts 151 disposed in the display area AA. The second metal layer 70 is disposed between the second inorganic insulation layer 21 and the third inorganic insulation layer 22, and the second metal layer 70 includes a plurality of gates and first capacitive electrodes disposed in the display area AA, and the gates corresponds to the active parts 151. The third metal layer 80 is disposed between the third inorganic insulation layer 22 and the fourth inorganic insulation layer 23. The third metal layer 80 includes a plurality of gates and second capacitive electrodes disposed in the display area AA, and the second capacitive electrodes corresponds to the first capacitive electrodes. A gate formed by the second metal layer 70 is the first gate 71, and a gate formed by the third metal layer 80 is the second gate 81. The first gate 71 and the second gate 81 are correspondingly disposed.

The organic insulation layer 40 is disposed on a side of the inorganic insulation layer 20 away from the substrate 10, and extends from the display area AA to a part of the transition area TA. A material of the organic insulation layer 40 is an organic material.

The display panel 100 further includes a first planarization layer 41, a pixel definition layer 42 and a support layer 43 stacked sequentially on the first metal layer 30, and the organic insulation layer 40 is formed by at least one of the first planarization layer 41, the pixel definition layer 42 and the support layer 43. The pixel definition layer 42 is located on a side of the first planarization layer 41 away from the inorganic insulation layer 20, and the support layer 43 is disposed on the pixel definition layer 42.

Optionally, the organic insulation layer 40 further includes a second planarization layer 44 disposed between the first planarization layer 41 and the inorganic insulation layer 20. The first metal layer 30 is located between the first planarization g layer 41 and the second planarization layer 44. The display panel 100 further includes a fourth metal layer 90 which is located between the second planarization layer 44 and the inorganic insulation layer 20.

Referring to FIG. 3, the light emitting layer 50 and the first electrode layer 60 are both disposed on a side of the organic insulation layer 40 away from the inorganic insulation layer 20, and the first electrode layer 60 is covered on the light emitting layer 50. It should be noted that in order to clearly illustrate the structure of the metal barrier part 301 of the transition area TA in FIG. 2, the light emitting layer 50, the first electrode layer 60, and an encapsulation layer covering the first electrode layer 60 are not shown in FIG. 2.

Next, the specific structures formed by each film layer of the display panel 100 in different areas are elaborated below.

Referring to FIGS. 2 and 4, in the display area AA, a first gate 71 is formed by the second metal layer 70, a second gate 81 is formed by the third metal layer 80, a first source 91 and a first drain 92 are formed by the fourth metal layer 90, and a second source 31 is formed by the first metal layer 30. The first semiconductor layer 15, the first gate 71, the second gate 81, the first source 91, the first drain 92, and the second source 31 together form a first thin film transistor T1.

Specifically, the first semiconductor layer 15 is disposed on the substrate 10, and includes an active part 151 and a source area 152 and a drain area 153 located on both sides of the active part 151. The second inorganic insulation layer 21 covers the first semiconductor layer 15 and the substrate 10. The first gate 71 is disposed on the second inorganic insulation layer 21, and the first gate 71 corresponds to the active part 151 of the first semiconductor layer 15. The third inorganic insulation layer 22 covers the first gate 71 and the second inorganic insulation layer 21. The second gate 81 is disposed on the third inorganic insulation layer 22, and the second gate 81 and the first gate 71 are correspondingly disposed. The fourth inorganic insulation layer 23 covers the second gate 81 and the third inorganic insulation layer 22. The first source electrode 91 and the first drain electrode 92 are disposed on the fourth inorganic insulation layer 23, and the first source electrode 91 is electrically connected to the source area 152 of the first semiconductor layer 15, and the first drain electrode 92 is electrically connected to the drain area 153 of the first semiconductor layer 15.

The second planarization layer 44 covers the fourth inorganic insulation layer 23, and the second source electrode 31 is disposed on the second planarization layer 44, and the second source electrode 31 is electrically connected to the first source electrode 91. The first planarization layer 41 covers the second source electrode 31 and the second planarization layer 44.

The display panel 100 further includes a second electrode 61 which is disposed on the first planarization layer 41. The pixel definition layer 42 covers the second electrode 61 and the first planarization layer 41, and the pixel definition layer 42 is provided with a pixel opening at a position corresponding to the second electrode 61. The light emitting layer 50 is disposed on the second electrode 61 within the pixel opening, and the first electrode layer 60 is disposed on the light emitting layer 50. The light emitting layer 50 emits light under the joint action of the first electrode layer 60 and the second electrode 61. Optionally, the second electrode 61 is an anode, and the first electrode layer 60 is a cathode.

In order to protect the light emitting layer 50 and prevent water oxygen intrusion from causing its failure, the display panel 100 further includes an encapsulation layer (not shown in the figure), which covers the first electrode layer 60. The encapsulation layer may adopt thin film encapsulation, for example, the encapsulation layer may be a layered structure formed by sequentially stacking three layers of thin films, namely a first inorganic encapsulation layer, the organic encapsulation layer, and the second inorganic encapsulation layer, or a layered structure with more layers. Materials of the organic encapsulation layer include one or several organic materials such as epoxy series and acrylic series, and the organic encapsulation layer may be coated on the first inorganic encapsulation layer through one of the ink jet printing (IJP), spraying and other coating processes.

Next, the film structure of the transition area TA is described in detail as follows.

Continuing with reference to FIG. 2, in the transition area TA, a first gate 71 and a first signal connection line 72 are further formed by the second metal layer 70, a second gate 81 and a second signal connection line 82 are further formed by the third metal layer 80, a first source 91 and a third signal connection line 93 are formed by the fourth metal layer 90, and a second source 31 and a fourth signal connection line 32 are further formed by the first metal layer 30. The first gate 71, the second gate 81, the first source 91, and the second source 31 are located in the dummy pixel area DA. The first signal connection line 72, the second signal connection line 82, the third signal connection line 93, and the fourth signal connection line 32 are located in the winding area RA.

Furthermore, in the transition area TA, a plurality of metal barrier parts 301 are further formed by the first metal layer 30, which are located in the first subarea SA1 and the second subarea SA2. A surface of the fourth inorganic insulation layer 23 is provided with a convex part 231, and the metal barrier part 301 is disposed on a side of the convex part 231 away from the substrate 10. A pad layer structure in the transition area TA is formed by at least one of the second metal layer 70 and the third metal layer 80, for example, the second metal layer 70 further includes a first pad layer structure disposed in the transition area TA and corresponding to the metal barrier part 301, and/or the third metal layer 80 further includes a second pad layer structure disposed in the transition area TA and corresponding to the metal barrier part 301. In an embodiment, preferably, a second pad layer structure 501 is formed in the first subarea SA1 and the second subarea SA2 by the third metal layer 80. The fourth inorganic insulation layer 23 cover the second pad layer structures 501, and the convex part 231 is formed on the corresponding second pad layer structure 501 by the fourth inorganic insulation layer 23.

Optionally, the transition area TA further includes a third subarea SA3, which is located between the first subarea SA1 and the second subarea SA2. A barrier wall 601 is provided within the third subarea SA3, and the barrier wall 601 is located on a side of the inorganic insulation layer 20 away from the substrate 10, and surrounds the functional area HA. The barrier wall 601 is formed by at least one of the first planarization layer 41, the pixel definition layer 42 and the support layer 43. Referring to FIG. 2, the barrier wall 601 is formed by the first planarization layer 41, and a shape of the barrier wall 601 is trapezoidal. The barrier wall 601 may serve as a secondary barrier and a slight crack prevention effect when inkjet printing slightly overflows.

Furthermore, the insulation part 401is formed by at least one of the first planarization layer 41, the pixel definition layer 42 and the support layer 43. Referring to FIG. 2, exemplarily, the insulation part 401 is formed by the first flattened layer 41. One side of the metal barrier part 301 is covered by the insulation part 401.

In an embodiment, the first subarea SA1 is provided with a metal barrier part 301, the insulation part 401 is located within the first subarea SA1, and the insulation part 401 is located at a side of the metal barrier part 301 away from the display area AA, so that after the first electrode layer 60 is disconnected at the first subarea SA1, the first electrode layer 60 located in the first subarea SA1 close to the functional area HA is capable of not forming an electric field. Of course, the present disclosure is not limited to this. The insulation part 401 of the present disclosure may further be located at a side of the metal barrier part 301 close to the display area AA.

Specifically, referring to FIG. 2 and FIG. 3, the metal barrier part 301 is disposed on the convex part 231 to increase a height of the metal barrier part 301, making it easier for the disconnection structure 300 of the metal barrier part 301 to disconnect the light emitting layer 50 and the first electrode layer 60 at the disconnection structure 300. Optionally, an orthogonal projection of the metal barrier part 301 on the substrate 10 falls within an orthogonal projection of the convex part 231 on the substrate 10, so that a size of the metal barrier part 301 is less than or equal to a size of the convex part 231, in order to enhance the fixed stability of the metal barrier part 301 and avoid collapse of the metal barrier part 301.

Optionally, an orthogonal projection of the metal barrier part 301 on the substrate 10 may also cover an orthogonal projection of the convex part 231 on the substrate 10, so that a size of the metal barrier part 301 is larger than a size of the convex part 231. Therefore, a disconnection structure 300 may also be formed between the metal barrier part 301 and the convex part 231, making it easier for the light emitting layer 50 and the first electrode layer 60 to be disconnected.

Furthermore, the insulation part 401 is disposed at one side of the metal barrier part 301, and the insulation part 401 covers the side of the metal barrier part 301. Specifically, the metal barrier part 301 includes an upper surface 302 that is away from the convex part 231, as well as a first side surface303 and a second side surface 304 connecting the upper surface 302. The first side surface 303 is close to the display area AA, and the second side surface 304 is away from the display area AA. The insulation part 401 is disposed on the second side surface 304 of the metal barrier part 301, and covers the second side surface 304 and a part of the upper surface 302. The insulation part 401 further covers a part of the convex part 231.

at least one of the first side 303 surface and the second side surface 304 of the metal barrier part 301 is provided with a disconnection structure 300. Of course, in order to ensure that the light emitting layer 50 and the first electrode layer 60 are disconnected at the metal barrier part 301, a side surface of the metal barrier part 301 that is not covered by the insulation part 401 needs to be provided with a disconnection structure 300. That is, a side surface of the metal barrier part 301 that is covered by the insulation part 401 may be provided with or without a disconnection structure 300.

Continuing with reference to FIG. 3, the light emitting layer 50 is disconnected at the disconnection structure 300 of the metal barrier part 301 to block the formation of a water oxygen transport path by the light emitting layer 50. The light emitting layer 50 located at one side of the metal barrier part 301 covers a part of the third inorganic insulation layer 22 and the convex part 231, and the light emitting layer 50 located at another side of the metal barrier part 301 covers the metal barrier part 301, the insulation part 401 and the third inorganic insulator layer 22. The light emitting layer 50 located on the one side of the metal barrier part 301 is disconnected from the light emitting layer 50 located on the another side of the metal barrier part 301 through the disconnection structure 300.

The first electrode layer 60 is also disconnected at the disconnection structure 300. The first electrode layer 60 located at one side of the metal barrier part 301 is electrically connected to the metal barrier part 301, and the first electrode layer 60 located at another side of the metal barrier part 301 is insulated with the metal barrier part 301 through the insulation part 401. The one side of the metal barrier part 301 and the another side of the metal barrier part 301 refer to opposite two sides of the metal barrier part 301, namely the first side surface 303 and the second side surface 304 of the metal barrier part 301.

The disconnection structure 300 of the metal barrier part 301 is elaborated in detail below.

Referring to FIG. 5, the metal barrier part 301 includes a first metal sublayer 3011, a second metal sublayer 3012 and a third metal sublayer 3013 disposed in layers. The second metal sublayer 3012 is located on a side of the first metal sublayer 3011 away from the inorganic insulation layer 20, and the third metal sublayer 3013 is located on a side of the second metal sublayer 3012 away from the inorganic insulation layer 20, A material of the second metal sub layer 3012 is different from that of the third metal sub layer 3013, and a width of the second metal sub layer 3012 is smaller than that of the third metal sub layer 3013. Specifically, an outer boundary of the second metal sublayer 3012 shrinks inward relative to an outer boundary of the third metal sublayer 3013 to form the disconnected structure 300. Optionally, the metal barrier part 301 is a laminated metal such as titanium-aluminum-titanium (Ti-Al-Ti), such as the first metal sublayer 3011 and the third metal sublayer 3013 being titanium layers, and the second metal sublayer 3012 being an aluminum layer. In this way, when etching the titanium-aluminum-titanium laminated metal under the same etching conditions, the aluminum layer is more easily etched than the titanium layer, causing the etched aluminum layer to shrink compared to the titanium layer, forming the metal barrier layer with the disconnected structure 300.

In the embodiment, by disposing the insulation part 401 in the first subarea SA1 closer to the display area AA, the first electrode layer 60 is disconnected earlier in the transition area TA, and an area of the first electrode layer 60 in the transition area TA that does not form an electric field is increased, thereby better avoiding the migration of K⁺ in the polarizer to the encapsulation layer for electrochemical reactions, further improving the reliability of encapsulation.

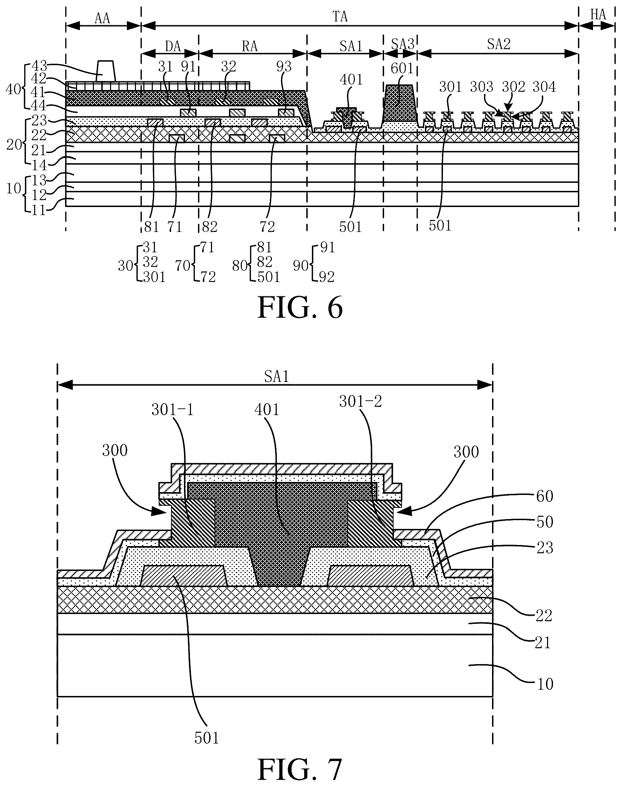

In an embodiment, referring to FIG 1 to FIG 7, FIG. 6 is another a cross-sectional schematic view along the direction A-A' in FIG. 1, and FIG. 7 is a detailed schematic view of the first subarea SA1 in FIG. 6. Unlike the above embodiments, the first subarea SA1 is provided with two metal barrier parts 301, the insulation part 401 is located within the first subarea SA1, and the insulation part 401 is filled in an interval area between the two metal barrier parts 301, as shown in FIG. 6.

Specifically, referring to FIG. 7, the insulation part 401 covers adjacent two sides of the two metal barrier parts 301, and sides of the adjacent two metal barrier parts 301 that are not covered by the insulation part 401 are provided with disconnection structures 300. The light emitting layer 50 is disconnected at the disconnection structure 300 of the adjacent two metal barrier parts 301, and the first electrode layer 60 is also disconnected at the disconnection structure 300 of the adjacent two metal barrier parts 301.

Specifically, the two metal barrier parts 301 are defined as a first metal barrier part 301-1 and a second metal barrier part 301-2, respectively. The first metal barrier part 301-1 and the second metal barrier part 301-2 are disposed adjacent to each other in the transition area TA, and the first metal barrier part 301-1 is disposed between the second metal barrier part 301-2 and the display area AA. A side of the first metal barrier part 301-1 close to the display area AA is provided with a disconnection structure 300, and A side of the second metal barrier part 301-2 close to the functional area HA is provided with a disconnection structure 300. The insulation part 401 simultaneously covers a side of the first metal barrier part 301-1 close to the functional area HA and a side of the second metal barrier part 301-2 close to the display area AA.

the light emitting layer 50 is disconnected at the disconnection structure 300 which is disposed at the side of the first metal barrier part 301-1 close to the display area AA, and is disconnected at the disconnection structure 300 which is disposed at the side of the second metal barrier part 301-2 close to the functional area HA, and the light emitting layer 50 is continuously disposed between the side of the first metal barrier part 301-1 close to the display area AA and the side of the second metal barrier part 301-2 close to the functional area HA.

The first electrode layer 60 is disconnected at the disconnection structure 300 which is disposed at the side of the first metal barrier part 301-1 close to the display area AA, and is disconnected at the disconnection structure 300 which is disposed at the side of the second metal barrier part 301-2 close to the functional area HA. A first electrode layer 60 located at the side of the first metal barrier part 301-1 close to the display area AA is electrically connected to the first metal barrier part 301-1, and a first electrode layer 60 located at the side of the second metal barrier part 301-2 close to the functional area HA is electrically connected to the second metal barrier part 301-2.

More specifically, after the first electrode layer 60 is disconnected at the disconnection structure 300 of the first metal barrier part 301-1, the first electrode layer 60 located at one side of the first metal barrier part 301-1 is electrically connected to the first metal barrier part 301-1, and the first electrode layer 60 located at another side of the first metal barrier part 301-1 is insulated with the first metal barrier part 301-1 through the insulation part 401.

The first electrode layer 60 located at the another side of the first metal barrier part 301-1 includes two parts. A first part is defined as a first electrode layer 60 located on a side of the first metal barrier part 301-1 and the second metal barrier part 301-2 away from the substrate 10, and a second part is defined as a first electrode layer 60 located at a side of the second metal barrier part 301-2 away from the insulation layer. The two parts of the first electrode layer 60 are formed by being disconnected by the disconnection structure 300 of the second metal barrier part 301-2. The first electrode layer 60 located at the side of the second metal barrier part 301-2 away from the insulation layer is electrically connected to the second metal barrier part 301-2, and the insulation part 401 separates the second metal barrier part 301-2 from the first metal barrier part 301-1, causing insulation between the first metal barrier part 301-1 and the second metal barrier part 301-2. So that, the first electrode layer 60 electrically connected to the first metal barrier part 301-1 is insulated with the first electrode layer 60 electrically connected to the second metal barrier part 301-2.

And the first electrode layer 60 located on the side of the first metal barrier 301-1 and the second metal barrier 301-2 away from the substrate 10 is coated on the light emitting layer 50, and the corresponding light emitting layer 50 is continuous. That is, the light emitting layer 50 sequentially covering a part of an upper surface of the first metal barrier 301-1, a surface of the insulating part 401 away from the substrate 10, and a part of an upper surface of the second metal barrier part 301-2 is continuous, so that the first electrode layer 60 covering the part of the light emitting layer 50 is insulated from the first metal barrier part 301-1 and the second metal barrier part 301-2. **In** this way, the first electrode layer 60 located at one side of the first metal barrier part 301-1 is electrically connected to the first metal barrier part 301-1, and the first electrode layer 60 located at another side of the first metal barrier part 301-1 is insulated with the first metal barrier part 301-1 through the insulation part 401.

Optionally, a same voltage is applied to the first metal barrier part 301-1 and the first electrode layer 60, and no voltage is applied to the second metal barrier part 301-2, meaning that the first metal barrier part 301-1 is closest to the display area AA, and there is no other metal barrier part 301 between the first metal barrier part 301-1 and the display area AA. **In** this way, the first electrode layer 60 may be disconnected earlier in the transition area TA to increase an area of the first electrode layer 60 that does not form an electric field in the transition area TA, thereby better avoiding the migration of K⁺ in the polarizer to the encapsulation layer for electrochemical reactions, further improving the reliability of encapsulation.

In the embodiment, by disposing the insulation part 401 between two adjacent metal barrier parts 301, the first electrode layer 60 close to the functional area HA and the first electrode layer 60 in the display area AA are insulated, so that the first electrode layer 60 close to the functional area HA does not form an electric field and thus does not cause K⁺ in the polarizer to migrate to the encapsulation layer, avoiding the occurrence of electrochemical reactions and improving the reliability of encapsulation, and the problem of encapsulation failure in the cutting edge area of the punch-hole screen may be solved.

Moreover, when the insulation part 401 is formed by the organic insulation layer 40 in the transition area TA, due to the fluidity of the organic material, the insulation part 401 is formed between two adjacent metal barrier parts 301, the adjacent two metal barrier parts 301 is capable of restricting the flow of the organic material, thereby forming a more stable structure of the insulation part 401. For other explanations, please refer to the above embodiments and may not be repeated here.

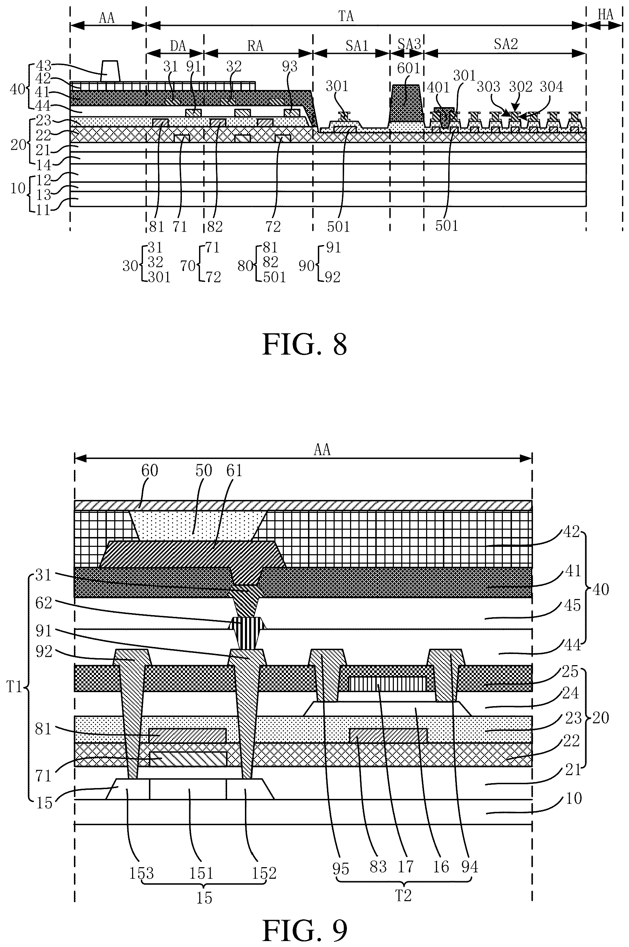

In an embodiment, please refer to FIGS.1 to 8. FIG. 8 is another a cross-sectional schematic view along the direction A-A' in FIG. 1. Unlike the above embodiments, referring to FIG. 8, the insulation part 401 is disposed in the second subarea SA2, and the insulation part 401 is filled in the interval area between the two adjacent metal barrier parts 301, By disposing the insulation part 401 in the second subarea SA2, it is also possible to achieve insulation between the first electrode layer 60 close to the functional area HA and the first electrode layer 60 in the display area AA, thereby preventing the first electrode layer 60 close to the functional area HA from forming an electric field. For other explanations, please refer to the above embodiments and may not be repeated here.

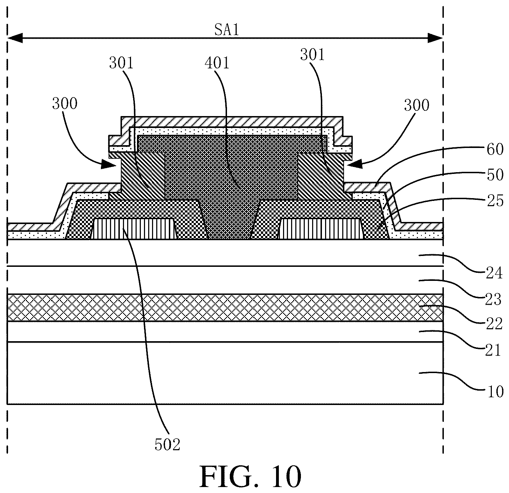

In an embodiment, referring to FIG.S 1 to 10, FIG. 9 is another detailed schematic view of the display area provided in an embodiment of the present disclosure, and FIG.10 is a detailed schematic view of the structure of the first subarea of the film layers in FIG. 9. Unlike the above embodiments, the display panel 100 adopts a low-temperature polycrystalline oxide (LTPO) thin film transistor, which includes a first thin film transistor T1 and a second thin film transistor T2. The first thin film transistor T1 is a low-temperature polycrystalline silicon thin film transistor, and the second thin film transistor T2 is a metal oxide thin film transistor. Due to the display panel 100 adopting the low-temperature polycrystalline oxide thin film transistors including more film layers, and correspondingly, in the transition area TA, the metal barrier part 301 and the pad layer structure may be formed from different metal layers.

Specifically, referring to FIG. 9, the inorganic insulation layer 20 is disposed on the substrate 10, the inorganic insulation layer 20 includes a second inorganic insulation sublayer 21, a third inorganic insulation sublayer 22, a fourth inorganic insulation sublayer 23, a fifth inorganic insulation sublayer 24, and a sixth inorganic insulation sublayer 25. The organic insulation layer 40 includes a first planarization layer 41, a pixel definition layer 42, a second planarization layer 44, and a third planarization layer 45. The first thin film transistor T1 includes a first semiconductor layer 15, a first gate 71, a second gate 81, a first source 91, a first drain 92, a second source 31, and a third source 62. The second thin film transistor T2 includes a second semiconductor layer 16, a third gate 83, a fourth gate 17, a fourth source 94, and a second drain 95.

Referring to FIG.S 9 and 10, a third pad layer structure 502 is formed in the transition area TA by a metal layer by which the fourth gate 17 is formed in the display area AA. For other explanations, please refer to the above embodiments and may not be repeated here.

Based on the same inventive concept, an electronic device is provided by the embodiment of the present disclosure provides, the electronic device includes a functional component and a display panel 100 in one of the foregoing embodiments, and the functional component corresponds to the functional area of the display panel. The electronic device may be a wearable device, such as a smart bracelet, a smartwatch, or a virtual reality (VR) device, as well as a mobile phone, an e-book, an electronic newspaper, a television, or a personal laptop. It may also be a flexible organic light-Emitting diode (OLED) display or a lighting device that may be bent and folded. The specific form of the electronic device is not specifically limited in the embodiments of the present disclosure.

According to the above embodiments, it may be obtained that:
a display panel and electronic device are provided by the present disclosure, the display panel includes a functional area, a display area adjacent to the functional area, and a transition area located between the functional area and the display area. The first metal layer of the display panel is disposed on a side of the inorganic insulation layer away from the substrate, at least one metal barrier part is disposed in the transition area, and at least one side of the metal barrier part is provided with the disconnection structure. The organic insulation layer is provided with the insulation part which covers one side of the metal barrier part and is in the transition area. The light emitting layer and the first electrode layer are disconnected at the disconnection structure. The first electrode layer located at one side of the metal barrier part is electrically connected to the metal barrier part, and the first electrode layer located at another side of the metal barrier part is insulated with the metal barrier part through the insulation part. Therefore, the first electrode layer close to the functional area is insulated with and the first electrode layer in the display area, and the first electrode layer close to the functional area may not form an electric field, thereby preventing a migration of K⁺ in a polarizer to an encapsulation layer and electrochemical reactions, and solving the problem of encapsulation failure in the cutting edge area of the punch-hole screen of the prior art. **In** addition, the metal barrier part of the metal barrier part provided with the insulation part close to the functional area is not electrified and may not form an electric field to affect the encapsulation effect of the functional area.

**In** the foregoing embodiments, the descriptions of the embodiments have their respective focuses. For a part that is not described in detail in an embodiment, reference may be made to related descriptions in other embodiments.

The embodiments of the present disclosure are described in detail above. The principle and implementations of the present disclosure are described in this specification by using specific examples. The description about the foregoing embodiments is merely provided to help understand the method and core ideas of the present disclosure. Persons of ordinary skill in the art should understand that they may still make modifications to the technical solutions described in the foregoing embodiments or make equivalent replacements to some technical features thereof, without departing from the scope of the technical solutions of the embodiments of the present disclosure.

## Claims

1. A display panel, comprising a functional area, a display area and a transition area located between the functional area and the display area, wherein the display panel further comprises:
a substrate;
an inorganic insulation layer disposed on a side of the substrate;
a first metal layer disposed on a side of the inorganic insulation layer away from the substrate, the first metal layer comprising at least one metal barrier part disposed in the transition area, at least one side of the metal barrier part being provided with a disconnection structure;
an organic insulation layer disposed on a side of the first metal layer away from the substrate, the organic insulation layer comprising at least one insulation part disposed in the transition area and covering corresponding one side of the metal barrier part;
a light emitting layer disposed on a side of the organic insulation layer away from the substrate, covering the display area and extending to the transition area, and disconnected at the disconnection structure of the metal barrier part; and
a first electrode layer disposed on a side of the light emitting layer away from the substrate, covering the display area and extending to the transition area, and disconnected at the disconnection structure of the metal barrier part;
wherein the first electrode layer located at one side of the metal barrier part is electrically connected to the metal barrier part, and the first electrode layer located at another side of the metal barrier part is insulated with the metal barrier part through the insulation part.

2. The display panel of claim 1, wherein the first metal layer comprises a plurality of metal barrier parts disposed in the transition area, wherein one side of at least one of the metal barrier parts is provided with the disconnection structure, and another side of the one of the metal barrier parts is covered by a corresponding insulation part.

3. The display panel of claim 2, wherein one side of at least one of the metal barrier parts close to the display area is provided with the disconnection structure, one side of the one of the metal barrier parts close to the functional area is covered by the corresponding insulation part, the one of the metal barrier parts is electrically connected with the first electrode layer close to the display area at the disconnection structure, and the one of the metal barrier parts is insulated with the first electrode layer close to the functional area through the insulation part.

4. The display panel of claim 2, wherein the first metal layer comprises a first metal barrier part and a second metal barrier part adjacent to each other disposed in the transition area, and the first metal barrier part is disposed between the second metal barrier part and the display area;
one side of the first metal barrier part close to the display area is provided with the disconnection structure, and one side of the second metal barrier part close to the functional area is provided with the disconnection structure;
one side of the first metal barrier part close to the functional area and one side of the second metal barrier part close to the display area are covered simultaneously by the insulation part;
the light emitting layer is disconnected at the disconnection structure which is disposed at the side of the first metal barrier part close to the display area, and is disconnected at the disconnection structure which is disposed at the side of the second metal barrier part close to the functional area, and the light emitting layer is continuously disposed between the side of the first metal barrier part close to the display area and the side of the second metal barrier part close to the functional area; and
the first electrode layer is disconnected at the disconnection structure which is disposed at the side of the first metal barrier part close to the display area, and is disconnected at the disconnection structure which is disposed at the side of the second metal barrier part close to the functional area, a first electrode layer located at the side of the first metal barrier part close to the display area is electrically connected to the first metal barrier part, and a first electrode layer located at the side of the second metal barrier part close to the functional area is electrically connected to the second metal barrier part.

5. The display panel of claim 4, wherein the display panel further comprises a barrier wall disposed in the transition area and disposed on a side of the inorganic insulation layer away from the substrate;
the transition area comprises a first subarea located between the barrier wall and the display area and a second subarea located between the barrier wall and the functional area; and
the organic insulation layer comprises at least one insulation part covering a corresponding side of the metal barrier part, and the insulation part is disposed in the first subarea and/or the second subarea.

6. The display panel of claim 5, wherein the first metal barrier part and the second metal barrier part are disposed in the first subarea; and
a same voltage is applied to the first metal barrier part and the first electrode layer, and no voltage is applied to the second metal barrier part.

7. The display panel of claim 1, wherein a number of insulation parts is less than or equal to a number of metal barrier parts.

8. The display panel of claim 1, wherein the metal barrier part comprises a first metal sublayer, a second metal sublayer and a third metal sublayer stacked sequentially, a material of the second metal sublayer is different from a material of the third metal sublayer, and a width of the second metal sublayer is smaller than a width of the third metal sublayer.

9. The display panel of claim 1, wherein the display panel further comprises a first planarization layer, a pixel definition layer and a support layer stacked sequentially on the first metal layer, and the organic insulation layer is formed by at least one of the first planarization layer, the pixel definition layer and the support layer.

10. The display panel of claim 1, wherein the inorganic insulation layer comprises a first inorganic insulation sublayer, a second inorganic insulation sublayer, a third inorganic insulation sublayer, and a fourth inorganic insulation sublayer stacked sequentially on the substrate; and
the display panel further comprises:
a semiconductor layer disposed between the first inorganic insulation sublayer and the second inorganic insulation sublayer, and comprising a plurality of active parts disposed in the display area;
a second metal layer disposed between the second inorganic insulation sublayer and the third inorganic insulation sublayer, and comprising a plurality of gates and a plurality of first capacitive electrodes disposed in the display area, wherein the gates correspond to the active parts; and
a third metal layer disposed between the third inorganic insulation sublayer and the fourth inorganic insulation sublayer, and comprising a plurality of second capacitive electrodes disposed in the display area, wherein the second capacitive electrodes correspond to the first capacitive electrodes;
wherein, the second metal layer further comprises a first pad layer structure disposed in the transition area and corresponding to the metal barrier part, and/or the third metal layer further comprises a second pad layer structure disposed in the transition area and corresponding to the metal barrier part.

11. An electronic device, comprising a functional component and a display panel, the display panel comprising a functional area, a display area and a transition area located between the functional area and the display area, and the functional component corresponding to the functional area of the display area, wherein the display panel further comprises:
a substrate;
an inorganic insulation layer disposed on a side of the substrate;
a first metal layer disposed on a side of the inorganic insulation layer away from the substrate, the first metal layer comprising at least one metal barrier part disposed in the transition area, at least one side of the metal barrier part being provided with a disconnection structure;
an organic insulation layer disposed on a side of the first metal layer away from the substrate, the organic insulation layer comprising at least one insulation part disposed in the transition area and covering corresponding one side of the metal barrier part;
a light emitting layer disposed on a side of the organic insulation layer away from the substrate, covering the display area and extending to the transition area, and disconnected at the disconnection structure of the metal barrier part; and
a first electrode layer disposed on a side of the light emitting layer away from the substrate, covering the display area and extending to the transition area, and disconnected at the disconnection structure of the metal barrier part;
wherein, the first electrode layer located at one side of the metal barrier part is electrically connected to the metal barrier part, and the first electrode layer located at another side of the metal barrier part is insulated with the metal barrier part through the insulation part.

12. The electronic device of claim 11, wherein the first metal layer comprises a plurality of metal barrier parts disposed in the transition area, wherein one side of at least one of the metal barrier parts is provided with the disconnection structure, and another side of the one of the metal barrier parts is covered by a corresponding insulation part.

13. The electronic device of claim 12, wherein one side of at least one of the metal barrier parts close to the display area is provided with the disconnection structure, one side of the one of the metal barrier parts close to the functional area is covered by the corresponding insulation part, the one of the metal barrier parts is electrically connected with the first electrode layer close to the display area at the disconnection structure, and the one of the metal barrier parts is insulated with the first electrode layer close to the functional area through the insulation part.

14. The electronic device of claim 12, wherein the first metal layer comprises a first metal barrier part and a second metal barrier part adjacent to each other disposed in the transition area, and the first metal barrier part is disposed between the second metal barrier part and the display area;
one side of the first metal barrier part close to the display area is provided with the disconnection structure, and one side of the second metal barrier part close to the functional area is provided with the disconnection structure;
one side of the first metal barrier part close to the functional area and one side of the second metal barrier part close to the display area are covered simultaneously by the insulation part;
the light emitting layer is disconnected at the disconnection structure which is disposed at the side of the first metal barrier part close to the display area, and is disconnected at the disconnection structure which is disposed at the side of the second metal barrier part close to the functional area, and the light emitting layer is continuously disposed between the side of the first metal barrier part close to the display area and the side of the second metal barrier part close to the functional area; and
the first electrode layer is disconnected at the disconnection structure which is disposed at the side of the first metal barrier part close to the display area, and is disconnected at the disconnection structure which is disposed at the side of the second metal barrier part close to the functional area, a first electrode layer located at the side of the first metal barrier part close to the display area is electrically connected to the first metal barrier part, and a first electrode layer located at the side of the second metal barrier part close to the functional area is electrically connected to the second metal barrier part.

15. The electronic device of claim 14, wherein the display panel further comprises a barrier wall disposed in the transition area and disposed on a side of the inorganic insulation layer away from the substrate;
the transition area comprises a first subarea located between the barrier wall and the display area and a second subarea located between the barrier wall and the functional area; and
the organic insulation layer comprises at least one insulation part covering corresponding one side of the metal barrier part, and the insulation part is disposed in the first subarea and/or the second subarea.

16. The electronic device of claim 15, wherein the first metal barrier part and the second metal barrier part are disposed in the first subarea; and
a same voltage is applied to the first metal barrier part and the first electrode layer, and no voltage is applied to the second metal barrier part.

17. The electronic device of claim 11, wherein a number of insulation parts is less than or equal to a number of metal barrier parts.

18. The electronic device of claim 11, wherein the metal barrier part comprises a first metal sublayer, a second metal sublayer and a third metal sublayer stacked sequentially, a material of the second metal sublayer is different from a material of the third metal sublayer, and a width of the second metal sublayer is smaller than a width of the third metal sublayer.

19. The electronic device of claim 11, wherein the display panel further comprises a first planarization layer, a pixel definition layer and a support layer stacked sequentially on the first metal layer, and the organic insulation layer is formed by at least one of the first planarization layer, the pixel definition layer and the support layer.

20. The electronic device of claim 11, wherein the inorganic insulation layer comprises a first inorganic insulation sublayer, a second inorganic insulation sublayer, a third inorganic insulation sublayer, and a fourth inorganic insulation sublayer stacked sequentially on the substrate; and
the display panel further comprises:
a semiconductor layer disposed between the first inorganic insulation sublayer and the second inorganic insulation sublayer, and comprising a plurality of active parts disposed in the display area;
a second metal layer disposed between the second inorganic insulation sublayer and the third inorganic insulation sublayer, and comprising a plurality of gates and a plurality of first capacitive electrodes disposed in the display area, wherein the gates correspond to the active parts; and
a third metal layer disposed between the third inorganic insulation sublayer and the fourth inorganic insulation sublayer, and comprising a plurality of second capacitive electrodes disposed in the display area, wherein the second capacitive electrodes correspond to the first capacitive electrodes;
wherein, the second metal layer comprises a first pad layer structure disposed in the transition area and corresponding to the metal barrier part, and/or the third metal layer comprises a second pad layer structure disposed in the transition area and corresponding to the metal barrier part.
